Europäisches Patentamt

European Patent Office

Office européen des brevets

(19)

(11) Veröffentlichungsnummer: **0 096 944 B1**

(12) **EUROPÄISCHE PATENTSCHRIFT**

(45) Veröffentlichungstag der Patentschrift:
04.12.85

(51) Int. Cl.⁴: **H 03 F 3/72, H 03 K 17/16**

(21) Anmeldenummer: **83200872.6**

(22) Anmeldetag: **15.06.83**

(54) Schaltungsanordnung mit mehreren, durch aktive Schaltungen gebildeten Signalpfaden.

(30) Priorität: **16.06.82 DE 3222607**

(43) Veröffentlichungstag der Anmeldung:
**28.12.83 Patentblatt 83/52**

(45) Bekanntmachung des Hinweises auf die Patenterteilung:
**04.12.85 Patentblatt 85/49**

(84) Benannte Vertragsstaaten:
**DE FR GB**

(56) Entgegenhaltungen:
**DE - A - 2 837 476
DE - A - 3 132 402
DE - B - 2 409 751
DE - B - 2 411 713
DE - B - 2 851 410
DE - C - 2 506 034
US - A - 2 970 227
US - A - 3 783 307
US - A - 4 236 088**

(73) Patentinhaber: **Philips Patentverwaltung GmbH,
Billstrasse 80, D-2000 Hamburg 28 (DE)**

(84) Benannte Vertragsstaaten: **DE**

(73) Patentinhaber: **N.V. Philips' Gloeilampenfabrieken,
Groenewoudseweg 1, NL-5621 BA Eindhoven (NL)**

(84) Benannte Vertragsstaaten: **FR GB**

(72) Erfinder: **Graffenberger, Wilhelm, Kanadaweg 5,
D-2000 Hamburg 73 (DE)**
Erfinder: **Kilian, Ernst-August, Kollaustrasse 125,
D-2000 Hamburg 61 (DE)**
Erfinder: **Dijkmans, Else Carel, Genovevalaan 99,
NL-5625 EB Eindhoven (NL)**

(74) Vertreter: **Hartmann, Heinrich, Dipl.-Ing. et al, Philips
Patentverwaltung GmbH
Billstrasse 80 Postfach 10 51 49,
D-2000 Hamburg 28 (DE)**

## Beschreibung

Die Erfindung betrifft eine Schaltungsanordnung mit mehreren, durch aktive Schaltungen gebildeten Signalpfaden, über die Signale mit unterschiedlichen Pegel einem gemeinsamen Ausgang zugeführt werden und die durch je eine schaltbare Stromquelle aktivierbar sind.

Eine solche Schaltungsanordnung ist im wesentlichen aus der DE-AS 2 506 034 bekannt. Allerdings ist der gemeinsame Ausgang über die verschiedenen Signalpfade mit unterschiedlichen Signalquellen verbunden, so daß die Schaltungsanordnung als Signalquellenumschalter wirkt. Doch ist es auch grundsätzlich möglich, die über die verschiedenen Signalpfade zuführbaren Signale von einer gemeinsamen Signalquelle, jedoch mit unterschiedlicher Amplitude oder unterschiedlichem Frequenzgang abzuleiten, wie an sich aus der DE-OS 3 132 402 bekannt.

Aufgrund unvermeidbarer Streuungen bei der Herstellung der als Signalpfad dienenden aktiven Schaltungen können dabei beim Umschalten Offset-Spannungen auftreten, die dazu führen, daß sich beim Umschalten die Ausgangsgleichspannung geringfügig ändert. Diese Änderung wird in einem angeschlossenen Lautsprecher als Knack hörbar.

Weiterhin ist aus der US-PS 4 236 088 eine Schaltungsanordnung mit mehreren Signalpfaden bekannt, über die eines von mehreren Eingangssignalen einem gemeinsamen Ausgang zugeführt werden kann. Jeder Signalpfad enthält dabei einen Differenzverstärker mit einer Konstantstromquelle. An die Ausgänge der Differenzverstärker sind steuerbare Schalter angeschlossen, denen während der Übergangsphase von einem Signalpfad auf einen anderen exponentiell ansteigende und abfallende Steuerspannungen zugeführt werden. Dadurch sollen Knackgeräusche beseitigt werden.

Aufgabe der vorliegenden Erfindung ist es, eine Schaltungsanordnung der eingangs genannten Art so auszugestalten, daß die auf die geschilderte Weise erzeugten Knackgeräusche beseitigt werden.

Diese Aufgabe wird durch folgende Maßnahmen gelöst:

a) Jede Stromquelle wird durch wenigstens ein $I^2L$-Gatter gebildet,

b) die $I^2L$-Gatter sind in eine erste und eine zweite Gruppe eingeteilt, wobei die Injektoranschlüsse der ersten Gruppe mit einem ersten Sammelpunkt und die Injektoranschlüsse der zweiten Gruppe mit einem zweiten Sammelpunkt verbunden sind,

c) die Steuereingänge der $I^2L$-Gatter sind so gesteuert, daß beim Übergang von einem Signalpfad auf einen anderen zwei zu je einem der Signalpfade und zu je einer der Gruppe gehörende $I^2L$-Gatter zumindest während einer Übergangsphase Strom führen können,

d) die Sammelpunkte sind so gewählt, daß während der Übergangsphase sich die Ausgangsströme der beiden $I^2L$-Gatter kontinuierlich und gegensinnig ändern.

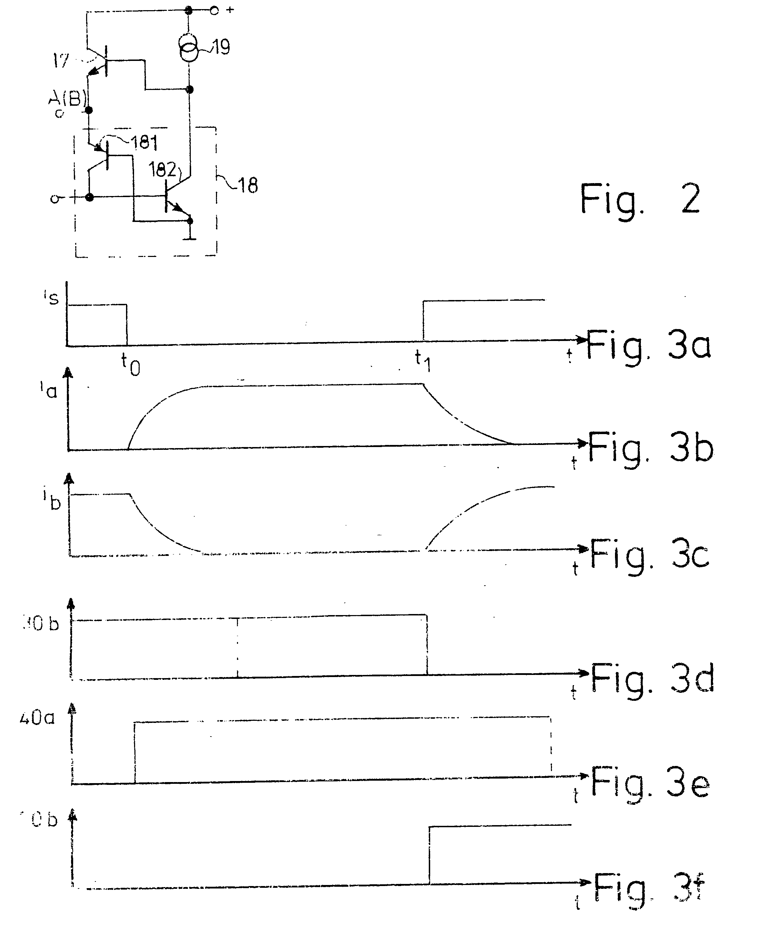

Der Strom zum Aktivieren eines Signalpfades wird also von einem damit gekoppelten $I^2L$-Gatter geliefert. Als $I^2L$-Gatter wird dabei und im folgenden eine auf dem Prinzip der integrierten Injektionslogik basierende Schaltung bezeichnet, die aus einem Inverter und einem Injektor besteht. Der Inverter ist ein vertikaler, invers betriebener npn-Transistor mit wenigstens einer Kollektorzone, die den Ausgang des $I^2L$-Gatters bildet. In dem Halbleitersubstrat ist in der Nähe dieser Transistorstruktur ein p-leitendes Gebiet angeordnet, das zusammen mit der Emitter- und der Basiszone des Inverters einen lateralen pnp-Transistor bildet — den sogenannten Injektor —, wobei die Kollektorzone des Injektors durch die Basiszone und die Basiszone des Injektors durch die Emitterzone des Inverters gebildet wird. Der Ausgangsstrom des $I^2L$-Gatters wird durch den Strom bestimmt, der im Injektoranschluß zugeführt wird. Ob dieser Ausgangsstrom überhaupt fließt, hängt vom Signal am Steuereingang des $I^2L$-Gatters ab, das durch die Basis des Inverters gebildet wird. Derartige $I^2L$-Gatter sind bekannt (»Electronics« 6. Februar 1975, Seiten 83 bis 90, insbesondere Fig. 2, sowie »Valvo-Berichte« Band XVIII 1974, Seiten 215 bis 226, insbesondere Bild 1 und Bild 5).

Dadurch, daß gemäß der Erfindung beim Übergang von einem Signalpfad auf den anderen dem Injektoranschluß des eingeschalteten $I^2L$-Gatters des vorher leitenden Signalpfades, das zu der einen Gruppe gehört, ein abnehmender Strom zugeführt wird, während dem $I^2L$-Gatter des anderen Signalpfades, das zu der anderen Gruppe gehört, während der Übergangsphase ein zunehmender Strom zugeführt wird, ergibt sich ein gleitender Übergang, der in einem von dem Ausgangssignal der Schaltungsanordnung gespeisten Lautsprecher nicht hörbar werden kann.

Damit der jeweils aktivierte Signalpfad, d. h. die ihn bildende aktive Schaltung optimal betrieben werden kann, muß der vom $I^2L$-Gatter gelieferte Strom einen bestimmten Wert aufweisen. Der Ausgangsstrom eines $I^2L$-Gatters schwankt jedoch — bei konstantem Injektorstrom — beträchtlich aufgrund der Tatsache, daß die Stromverstärkungsfaktoren des Inverters und des Injektors eines $I^2L$-Gatters starken Fertigungsstreuungen unterworfen sind. Nach einer Weiterbildung der Erfindung wird ein annähernd konstanter Ausgangsstrom jedoch dadurch erreicht, daß der erste und der zweite Sammelpunkt mit dem Ausgang eines ersten und eines zweiten Verstärkers sowie mit dem Injektoranschluß eines ersten bzw. zweiten Referenz-$I^2L$-Gatters verbunden sind, dessen Ausgang mit dem Eingang des ersten und des zweiten Verstärkers verbunden ist, und daß eine Stromquellenanordnung vorgesehen ist, die den Eingängen der beiden Verstärker sich während der Übergangsphase gegensinnig ändernde Ströme zuführt.

Durch den (ersten bzw. zweiten) Verstärker wird erzwungen, daß der Ausgangsstrom des zugehörigen I2L-Gatters dem von der Stromquellenanordnung zugeführten Strom entspricht. Dadurch wird in Abhängigkeit von den Fertigungsstreuungen die Spannung am Ausgang des Verstärkers — d. h. am Injektoranschluß des zugehörigen Referenz-Gatters bzw. an dem zugehörigen Sammelpunkt — auf einen solchen Wert gebracht, daß der Ausgangsstrom des Referenz-I2L-Gatters den erforderlichen Wert annimmt. Da die auf dem gleichen Halbleitersubstrat angebrachten anderen I2L-Gatter im wesentlichen die gleiche Eigenschaft haben, entspricht ihr Ausgangsstrom dem des I2L-Gatters.

Die Erfindung wird nachstehend anhand der Zeichnungen näher erläutert. Es zeigt

Fig. 1 ein Ausführungsbeispiel der Erfindung,

Fig. 2 den Aufbau des Verstärkers und des Referenz-I2L-Gatters, und

Fig. 3a bis 3f den zeitlichen Verlauf der Signale an verschiedenen Punkten der Schaltung nach Fig. 1.

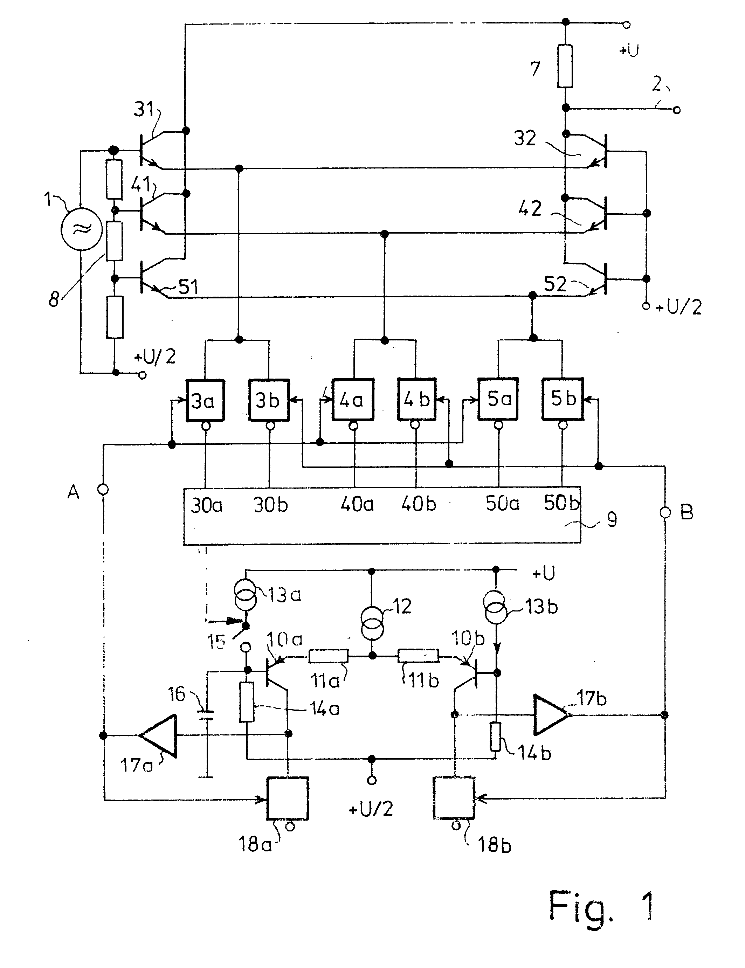

Die in Fig. 1 dargestellte Schaltung, die als Lautstärkesteller in einem Audio-Verstärker wirken kann, umfaßt eine Vielzahl von Signalpfaden (in der Zeichnung sind zwecks übersichtlicherer Darstellung lediglich drei dargestellt), über die die Signale einer Signalquelle 1 mit unterschiedlicher Amplitude einem gemeinsamen Ausgang 2 zugeführt werden können. Jeder Signalpfad kann einen Differenz-Verstärker enthalten, dessen Versorgungsgleichstrom ein- und ausgeschaltet wird, wie aus der DE-AS 2 506 034 bekannt. Im vorliegenden Ausführungsbeispiel werden die die Signalpfade bildenden Differenz-Verstärker durch je ein emittergekoppeltes npn-Transistorpaar gebildet. Das erste Transistorpaar umfaßt einen Transistor 31, dessen Basis mit dem einen Anschluß der Signalquelle 1 verbunden ist, deren anderer Anschluß an ein geeignetes Potential (+U/2) angeschlossen ist. Der Kollektor des Transistors 31 ist an eine positive Speisespannung (+U) angeschlossen, während sein Emitter mit dem Emitter eines Transistors 32 verbunden ist, dessen Kollektor über einen Widerstand 7 mit Masse verbunden ist, wobei der Verbindungspunkt des Kollektors und des Widerstandes 7 den gemeinsamen Ausgang 2 bildet. Das zweite Transistorpaar enthält einen Transistor 41, dessen Basis mit einem Abgriff eines an die Signalquelle 1 angeschlossenen Spannungsteilers 8 verbunden ist und dessen Emitter mit dem Emitter eines Transistors 42 verbunden ist, dessen Kollektor an den gemeinsamen Ausgang 2 angeschlossen ist. Das dritte Transistorpaar wird durch die Transistoren 51 und 52 gebildet, die genauso geschaltet ist wie die anderen Transistorpaare mit dem einzigen Unterschied, daß die Basis des Transistors 51 an den Abgriff des Spannungsteilers angeschlossen ist, der die niedrigste Signalspannung führt. Im übrigen sind die Basen der Transitoren 32, 42 und 52 mit einer geeigneten Gleichspannung (+U/2) und die Kollektoren der Transistoren 31, 41 und 51 miteinander verbunden.

Welcher der drei Signalpfade jeweils wirksam ist, hängt davon ab, welchem der drei Transistorpaare ein Emitterstrom zugeführt wird. Zu diesem Zweck sind in die Emitterzuleitungen der Transistorpaare schaltbare Stromquellen aufgenommen. Die Stromquelle für das Transistorpaar 31 und 32 wird durch ein erstes I2L-Gatter 3a und ein zweites I2L-Gatter 3b gebildet, deren Ausgänge miteinander bzw. mit dem der Emitterleitung der Transistoren 31, 32 verbunden sind. Entsprechend wird die schaltbare Stromquelle für das Transistorpaar 41 und 42 durch die beiden I2L-Gatter 4a, 4b und die Stromquelle für die Transistorpaare 51 und 52 durch die beiden I2L-Gatter 5a und 5b gebildet. Die Injektoranschlüsse der I2L-Gatter 3a, 4a und 5a sind mit einem ersten Sammelpunkt A verbunden, während die Injektoranschlüsse der I2L-Gatter 3b, 4b und 5b miteinander und mit einem zweiten Sammelpunkt B verbunden sind. Ob eines der I2L-Gatter Strom führt — der dann von dem nicht näher dargestellten Masseanschluß des I2L-Gatters zu den Emitteranschlüssen der Transistoren führt —, hängt von den Signalen an den Ausgängen 30a ... 50b einer zweckmäßigerweise ebenfalls in I2L-Technik aufgebauten Logikschaltung 9 ab, die mit den Steuereingängen der I2L-Gatter 3a ... 5b verbunden sind: Führt der Steuereingang des I2L-Gatters (der durch die Basiselektrode seines Inverters gebildet wird) das gleiche Potential wie der Emitter des Inverters (in der Regel Masse) ist der Ausgangsstrom Null, weil die Basis-Emitter-Strecke des Inverters kurzgeschlossen ist; liegt hingegen kein solcher Kurzschluß vor (offener Steuereingang), kann über den Ausgang des I2L-Gatters ein Strom fließen, dessen Größe durch das Betriebspotential an bzw. den Strom durch die Sammelpunkte A und B bestimmt wird.

Wenn entsprechend z. B. das I2L-Gatter 3b durch das Signal am Ausgang 30b der Logikschaltung 9 leitend gemacht wird, fließt durch die Transistoren 31 und 32 ein Strom, der von dem Potential am Punkt B bzw. dem Strom durch den Punkt B abhängt. Entsprechendes gilt für die Transistoren 41 und 42, falls z. B. das I2L-Gatter 4a einen Strom führt, bzw. für die Transistoren 51 und 52, falls z. B. das I2L-Gatter 5b einen Strom führen kann.

Da die Transistorpaare 31 und 32, 41 und 42 bzw. 51 und 52 nicht identisch sein können, ergeben sich beim Übergang von einem Signalpfad auf den anderen Potentialsprünge, die sich insbesondere bei fehlendem Eingangssignal störend bemerkbar machen können.

Erfindungsgemäß wird nun das Potential an den Sammelpunkten A und B beim Übergang von einem Signalpfad auf den anderen gegensinnig geändert, und zwar derart, daß dem vorher leitenden Transistorpaar z. B. 31, 32) über das Gatter 3b ein bis auf Null abnehmender und dem anschließend leitenden Transistorpaar (z. B. 41, 42) ein zunehmender Strom (über das Gatter 4a) zugeführt wird, wobei die Summe der beiden Ströme vorzugsweise wenigstens annähernd konstant bleibt. Die Gatter 3a ... 5b müssen durch die Logikschaltung dabei so gesteuert werden, daß beim Übergang von einem Signalpfad auf den anderen ein I²L-Gatter eingeschaltet wird (z. B. 4a), dessen Injektoranschluß mit einem anderen Sammelpunkt verbunden ist als der Injektoranschluß des vor dem Übergang eingeschalteten I²L-Gatters (z. B. 3b). Außerdem müssen zumindest während der Übergangsphase beide Gatter (sich gegensinnig ändernde) Ströme ziehen. Dadurch ändert sich sowohl die Signalamplitude als auch das Gleichspannungspotential am gemeinsamen Ausgang 2 beim Übergang von einem Signalpfad auf einen anderen kontinuierlich, so daß störende Geräusche in einem angeschlossenen Lautsprecher nicht hörbar werden können.

Zur Erzeugung der beiden sich gegensinnig ändernden Betriebspotentiale an den Punkten A und B bzw. sich gegensinnig ändernder Ströme über die Punkte A und B sind eine Stromquellenanordnung mit zwei Ausgängen, zwei Verstärker und zwei Referenz-I²L-Gatter sowie eine schaltbare RC-Kombination vorgesehen.

Die Stromquellenanordnung umfaßt zwei Transistoren 10a und 10b, deren Emitter über zwei gleich große Widerstände 11a und 11b miteinander sowie mit einer Gleichstromquelle 12 verbunden sind. Die Aufteilung des von der Gleichstromquelle 12 gelieferten Gleichstromes auf die beiden Transistoren 10a und 10b hängt von der Basisspannung der beiden pnp-Transistoren 10a und 10b ab. Die Basis des Transistors 10b ist über eine Gleichstromquelle 13b mit einer positiven Gleichspannung (+U) sowie über einen Widerstand 14b mit einer geringeren positiven Gleichspannung (+U/2) verbunden. Die Basis des Transistors 10a ist über die Serienschaltung einer Gleichstromquelle 13a, die einen gleich großen Strom liefert wie die Quelle 13b, sowie einen durch die Logikschaltung 9 steuerbaren Schalter 15 mit der positiven Speisespannung verbunden und über einen Widerstand 14a, der doppelt so groß ist wie der Widerstand 14b, mit der geringer positiven Spannung (+U/2). Außerdem ist die Basis über einen Kondensator 16 mit Masse verbunden.

Bei der aus Fig. 1 ersichtlichen offenen Stellung des Schalters 15 ist das Basispotential an der Basis des Transistors 10b um den durch den Gleichstrom der Gleichstromquelle 13b an dem Widerstand 14b verursachten Spannungsabfall positiver als das Basispotential des Transistors 10a. Infolgedessen fließt der Strom der Gleichstromquelle 12 vollständig über den Transistor 10a. Wird nun der Schalter 15 geschlossen, beginnt der Kondensator 16 sich aufzuladen, wobei die Basisspannung des Transistors 10a immer positiver wird, bis sie gegenüber der Spannung an der Basis des Transistors 10b um den gleichen Betrag positiver ist, um den sie vorher — d. h. bei geöffnetem Schalter — negativer war als das Basispotential des Transistors 10b. Dieser kontinuierliche Übergang des Transistors 10a vom leitenden in den gesperrten Zustand wird begleitet durch eine exponentielle Abnahme des Kollektorstromes des Transistors 10a bis auf den Wert Null und eine entsprechende Zunahme des Kollektorstromes durch den Transistor 10b.

Wird danach der Schalter 15 wieder geöffnet, geht der Transistor 10a wiederum kontinuierlich in den leitenden Zustand und der Transistor 10b entsprechend in den gesperrten Zustand über, wobei die Kollektorströme wiederum exponentiell zu- bzw. abnehmen. Während einer in erster Linie durch die Zeitkonstante des aus dem Kondensator 16 und dem Widerstand 14a bestehenden Zeitgliedes bestimmten Übergangsphase nach dem Öffnen bzw. Schließen des Schalters 15 ändern sich die von der Stromquellenanordnung gelieferten Ausgangsströme — die Kollektorströme der Transistoren 10a und 10b — also kontinuierlich.

Zwei Hilfsschaltungen sorgen nun dafür, daß die Potentiale an den Sammelpunkten A und B sich derart ändern, daß die Ausgangsströme derjenigen I²L-Gatter, deren Injektoranschlüsse mit diesen Sammelpunkten verbunden sind, den gleichen Verlauf haben wie die Kollektorströme der Transistoren 10a und 10b. Jede der beiden Hilfsschaltungen besteht aus einem Verstärker 17a bzw. 17b, dessen Eingang mit dem Kollektor des Transistors 10a bzw. 10b sowie mit dem Ausgang eines Referenz-I²L-Gatters 18a bzw. 18b verbunden ist. Der Ausgang des Verstärkers 17a bzw. 17b ist einerseits mit dem Sammelpunkt A bzw. B und andererseits mit dem Injektoranschluß des Referenz-I²L-Gatters 18a bzw. 18b verbunden, so daß sich ein Regelkreis ergibt, der erzwingt, daß der Ausgangsstrom des I²L-Gatter 18a bzw. 18b im wesentlichen dem Kollektorstrom der Transistoren 10a bzw. 10b entspricht.

Die Wirkung der Hilfsschaltung wird aus dem in Fig. 2 dargestellten Detail-Schaltbild deutlicher.

Das Referenz-I²L-Gatter 18 (a oder b) besteht aus einem npn-Transistor 182, dessen Emitter mit Masse verbunden ist und der vorzugsweise mehrere miteinander verbundene Kollektoren aufweist, die den Ausgang des I²L-Gatters bilden. Der durch die Basis des Inverters gebildete Steuereingang bleibt bei den Referenz-Gattern immer offen, so daß stets ein Strom fließen kann. Dieser Strom wird von einem Injektor geliefert, der durch einen pnp-Transistor 181 gebildet wird, dessen Kollektor mit der Basis und dessen Basis mit dem Emitter des Inverter-Transistors 182 verbunden ist. Der Emitter des Transistors 181 stellt den Injektoranschluß des I²L-Gatters dar und ist einerseits mit einem der Sammelpunkte A bzw. B verbunden und andererseits mit dem Ausgang des Verstärkers 17 (a oder b), der in diesem Fall durch den Emitter eines npn-Transistors mit hohem Stromverstärkungsfaktor gebildet wird. Der Kollektor dieses Transistors ist an eine positive Speisespannung angeschlossen, während seine Basis mit dem Ausgang des $I^2L$-Gatters sowie mit dem Kollektor des Transistors 10a bzw. 10b verbunden ist, der in Fig. 2 durch eine Stromquelle 19 symbolisiert wird. In Abhängigkeit von den Streuungen des Stromverstärkungsfaktors des Injektors 181 und des Inverters 182 nimmt das Potential am Emitter des Transistors 17, d. h. am Sammelpunkt A bzw. B stets einen solchen Wert an, daß der Ausgangsstrom des Referenz-$I^2L$-Gatters ungefähr genauso groß ist wie der von der Stromquelle 19 gelieferte Strom, d. h. der Kollektorstrom des Transistors 10a bzw. 10b. Eine solche Hilfsschaltung nach Fig. 2 ist im Prinzip aus der DE-OS 2 837 476, insbesondere Fig. 3, bekannt.

Da die Stromquellen-Gatter 3a, 4a und 5a bzw. 3b, 4b und 5b auf dem gleichen Halbleitersubstrat angeordnet sind wie die Referenz-$I^2L$-Gatter 18a bzw. 18b und weil sie den gleichen Aufbau haben, führen sie, da ihr Injektoranschluß ebenso mit dem zugehörigen Sammelpunkt A bzw. B verbunden ist wie derjenige der Referenzgatter, den gleichen Ausgangsstrom wie diese — falls sie nicht durch die Logikschaltung 9 gesperrt sind. Infolgedessen nehmen auch die den Emittern der Transistorpaare 31 ... 52 zugeführten Ströme in gleicher Weise ab bzw. zu wie die Kollektorströme der Transistoren 10a und 10b.

Die Wirkung der in Fig. 1 dargestellten Schaltung soll mit Hilfe der Zeitdiagramme von Fig. 3a—f für den Fall einer Amplitudenherabsetzung am gemeinsamen Ausgang 2 erläutert werden.

Dazu sei zunächst angenommen, daß zu einem bestimmten Augenblick der Schalter 15 (schon längere Zeit) geschlossen sei. Dann ist der Transistor 10a gesperrt, während der Transistor 10b leitend ist. Dies ergibt sich aus Fig. 3a, in der der zeitliche Verlauf des Stromes über den Schalter 15 dargestellt ist. Wenn kein Strom über den Schalter fließt, ist der Schalter geöffnet, wenn ein Strom über den Schalter fließt, ist er geschlossen.

Fig. 3b zeigt den zeitlichen Verlauf des Stromes $i_a$ am Ausgang des Referenz-$I^2L$-Gatters 18a. Er ist in dem betreffenden Zeitpunkt gleich Null, weil auch der Kollektorstrom des Transistors 10a Null ist. Fig. 3c zeigt den zeitlichen Verlauf $i_b$ des Ausgangsstromes des Referenz-$I^2L$-Gatters 18b. Er hat zu dem betreffenden Zeitpunkt sein Maximum. Wenn weiterhin angenommen wird, daß von den mit dem Sammelpunkt B gekoppelten $I^2L$-Gattern lediglich das Gatter 3b an den zugehörigen Steuerausgang 30b durch die Logikschaltung 9 so gesteuert wird, daß es einen Ausgangsstrom führen kann, dann fließt einzig über das $I^2L$-Gatter 3b ein Strom. Der Schaltzustand am Ausgang 30b ergibt sich aus Fig. 3d, wobei ein von Null verschiedener Signalwert besagt, daß das zugehörige $I^2L$-Gatter leitend ist, während es im anderen Falle gesperrt ist. In diesem Stadium ist lediglich der durch die Transistoren 31 und 32 gebildete Signalpfad wirksam. Die Amplitude am Ausgang 2 hat ihren größten Wert.

Wenn zur Zeit $t_0$ die Amplitude herabgesetzt werden soll, führt die Logikschaltung 9 zwei Funktionen aus: Sie schaltet den Schalter 15 um, öffnet ihn also und ändert das Potential am Steuereingang 40a so, daß das zugehörige $I^2L$-Gatter 4a einen Ausgangsstrom liefern kann (vgl. Fig. 3e). Das bisher Strom führende Gatter 3b bleibt (zunächst noch) weiterhin leitend. Das Schließen des Schalters 15 hat eine exponentielle Abnahme des Ausgangsstromes des Referenz-$I^2L$-Gatters 18b bis auf den Wert Null zur Folge und eine entsprechende gegensinnige Zunahme des Ausgangsstromes des Referenz-$I^2L$-Gatters 18a. Infolgedessen nimmt der Strom durch das $I^2L$-Gatter 3b in gleicher Weise ab wie der Strom $i_b$ und der Strom durch das Referenz-Gatter in gleicher Weise zu wie der Strom $i_a$. Am Ende dieser Übergangsphase, deren Dauer im Millisekundenbereich (z. B. 30 ms) liegt, ist nun auch das Transistorpaar 41, 42 leitend, und die Amplitude am Ausgang ist entsprechend geringer. Während der Übergangsphase vollzieht sich eine allmähliche Abnahme der Amplitude und eine allmähliche Potentialverschiebung (falls überhaupt Offset-Spannungen vorhanden sind). Frühestens am Ende der Übergangsphase kann das Potential am Ausgang 30b der Logikschaltung 9 so geändert werden, daß das $I^2L$-Gatter 3b gesperrt wird, wie durch eine gestrichelte Linie in Fig. 3d angedeutet ist.

Wenn zur Zeit $t_1$ die Lautstärke weiter herabgesetzt wird, vollzieht die Logikschaltung 9 wiederum zwei Funktionen: Sie schaltet den Schalter 15 um, d. h. sie schließt ihn, und ändert das Potential am Steuereingang 50b so, daß das zugehörige $I^2L$-Gatter Strom führen kann. Spätestens zu diesem Zeitpunkt muß das Signal am Ausgang 30b so geändert sein, daß das $I^2L$-Gatter 3b keinen Ausgangsstrom mehr liefern kann.

Die Folge dieser Maßnahmen ist, daß der Strom $i_a$ wieder abnimmt, während der Strom $i_b$ wieder zunimmt, so daß der dem Emitterpaar 41, 42 über das $I^2L$-Gatter 4a zugeführte Strom allmählich abnimmt, während der dem Transistorpaar 51 und 52 zugeführte Strom zunimmt, bis am Ende der Übergangsphase nur noch die Transistoren 51 und 52 leitend sind, wobei das Ausgangssignal am gemeinsamen Ausgang 2 seine minimale Amplitude hat.

Wenn zu einem späteren Zeitpunkt die Lautstärke wieder schnell erhöht werden soll, wird gegebenenfalls das Transistorpaar 31 und 32 eingeschaltet, ohne daß zwischendurch das Transistorpaar 41 und 42 aktiviert wird. In diesem Fall muß jedoch das $I^2L$-Gatter 3a aktiviert werden. Wenn anschließend die Lautstärke wieder abgesenkt wird, führen nacheinander die $I^2L$-Gatter 4b und 5a einen Strom.

Falls beim Erhöhen der Lautstärke jedoch zwischendurch auch das Transistorpaar 41 und 42 eingeschaltet wird, führt zunächst wieder das $I^2L$-Gatter 4a und anschließend das $I^2L$-Gatter 3b

Strom. In diesem Fall werden die I²L-Gatter 3a, 4b und 5a gar nicht benötigt und jeder Signalpfad hat nur ein I²L-Gatter (3b, 4a bzw. 5a). Der Aufwand an I²L-Gattern ist dabei also halbiert, jedoch können die Signalpfade dann nicht in beliebiger Folge aktiviert werden, sondern nur so, daß nach einem Signalpfad, dessen Strom von einem I²L-Gatter geliefert wird, dessen Anschluß mit dem Sammelpunkt A verbunden ist, nur ein Signalpfad aktiviert wird, dessen Strom von einem I²L-Gatter geliefert wird, das mit dem Sammelpunkt B verbunden ist und umgekehrt.

Dabei ist es von Vorteil, wenn wie im geschilderten Fall die Injektoranschlüsse der mit den Signalpfaden gekoppelten I²L-Gatter in der Größenfolge der Eingangssignale an den Signalpfaden abwechselnd mit dem einen und mit dem anderen Sammelpunkt verbunden sind. Im allgemeinen sollten also die Injektoranschlüsse der I²L-Gatter, die mit den Signalpfaden verbunden sind, die das größte, das drittgrößte, das fünftgrößte usw. Eingangssignal verarbeiten müssen, z. B. mit dem Sammelpunkt A, und die I²L-Gatter, die den Signalpfaden zugeordnet sind, die das zweitgrößte, viertgrößte, sechstgrößte usw. Eingangssignal verarbeitet, mit dem Sammelpunkt B verbunden sein.

## Patentansprüche

1. Schaltungsanordnung mit mehreren, durch aktive Schaltungen gebildeten Signalpfaden, über die Signale mit unterschiedlichen Pegel einem gemeinsamen Ausgang zugeführt werden und die durch je eine schaltbare Stromquelle aktivierbar sind, gekennzeichnet durch folgende Merkmale:

a)    jede Stromquelle wird durch wenigstens ein I²L-Gatter (3a . . . 5b) gebildet,
b)    die I²L-Gatter sind in eine erste (3a, 4a, 5a) und eine zweite Gruppe (3b, 4b, 5b) eingeteilt, wobei die Injektoranschlüsse der ersten Gruppe mit einem ersten Sammelpunkt (A) und die Injektoranschlüsse der zweiten Gruppe mit einem zweiten Sammelpunkt (B) verbunden sind,
c)    die Steuereingänge der I²L-Gatter (3a . . . 5b) sind so gesteuert, daß beim Übergang von einem Signalpfad auf einen anderen zwei zu je einem der Signalpfade und zu je einer der Gruppen gehörende I²L-Gatter (z. B. 3b, 4a) zumindest während einer Übergangsphase Strom führen können,
d)    die Sammelpunkte (A, B) sind so gewählt, daß während der Übergangsphase sich die Ausgangsströme der beiden I²L-Gatter kontinuierlich und gegensinnig ändern.

2. Schaltungsanordnung nach Anspruch 1, dadurch gekennzeichnet, daß jedem Signalpfad nur ein I²L-Gatter zugeordnet ist und daß in der Größenfolge der Eingangsamplitude der Signalpfade die zugehörigen I²L-Gatter abwechselnd

der ersten und der zweiten Gruppe angehören.

3. Schaltungsanordnung nach Anspruch 1, dadurch gekennzeichnet, daß jede Stromquelle durch zwei I²L-Gatter (3a, 3b . . . 5a, 5b) gebildet wird, die den beiden Gruppen angehören und von denen jeweils allenfalls eines Strom führt.

4. Schaltungsanordnung nach Anspruch 1 bis 3, dadurch gekennzeichnet, daß der erste und der zweite Sammelpunkt (A, B) mit dem Ausgang eines ersten und eines zweiten Verstärkers (17a, 17b) sowie mit dem Injektoranschluß eines ersten bzw. zweiten Referenz-I²L-Gatters (18a, 18b) verbunden sind, dessen Ausgang mit dem Eingang des ersten und des zweiten Verstärkers verbunden ist, und daß eine Stromquellenanordnung (10a . . . 14a, 10b . . . 14b) vorgesehen ist, die den Eingängen der beiden Verstärker (17a, 17b) sich während der Übergangsphase gegensinnig ändernde Ströme zuführt.

5. Schaltungsanordnung nach Anspruch 4, dadurch gekennzeichnet, daß die Stromquellenanordnung ein emittergekoppeltes Transistorpaar (10a, 10b) enthält, in dessen gemeinsamer Emitterzuleitung eine Konstantstromquelle (12) angeordnet ist und dessen Basis-Differenzspannung durch wenigstens ein umladbares RC-Glied (14a, 16) bestimmt ist.

6. Schaltungsanordnung nach Anspruch 4 oder 5, dadurch gekennzeichnet, daß als Verstärker ein Transistor (17) mit hohem Stromverstärkungsfaktor dient, dessen Basis mit dem Ausgang des zugehörigen Referenz-I²L-Gatters und dessen Emitter mit dem Injektoranschluß dieses I²L-Gatters verbunden ist (Fig. 2).

## Claims

1. A circuit arrangement comprising several signal paths which are formed by active circuits and via which signals of different level are applied to a common output, each signal path being activatable by a switchable current source, characterized in that:

a)    each current source is formed by at least one I²L gate (3a . . . 5b),
b)    the I²L gates are divided between a first group (3a, 4a, 5a) and a second group (3b, 4b, 5b), the injector connections of the first group being connected to a first junction point (A) whilst the injector connections of the second group are connected to a second junction point (B),
c)    the control inputs of the I²L gates (3a . . . 5b) are driven so that when a switch-over occurs from one signal path to another signal path, two I²L gates each of which is associated with one of the signal paths and with one of the groups (for example, 3b, 4a) can conduct current at least during a transition phase,
d)    the junction points (A, B) are chosen so that the output currents of the two I²L gates vary continuously and in the opposite sense during the transition phase.

2. A circuit arrangement as claimed in Claim 1, characterized in that with each signal path there is associated only one $I^2L$ gate, the associated $I^2L$ gates alternately belonging to the first group and the second group in the order of magnitude of the input amplitude of the signal paths.

3. A circuit arrangement als claimed in Claim 1, characterized in that each current source is formed by two $I^2L$ gates (3a, 3b . . . 5a, 5b) which belong to both groups and at least one of which each time conducts current.

4. A circuit arrangement as claimed in the Claims 1 to 3, characterized in that the first and the second junction point (A, B) are connected to the output of a first and a second amplifier (17a, 17b) and to the injector connection of a first and a second reference $I^2L$ gate (18a, 18b), respectively, the output of which is connected to the input of the first and the second amplifier, there being provided a current source arrangement (10a . . . 14a, 10b . . . 14b) which supplies the inputs of the two amplifiers (17a, 17b) with currents which vary in an opposite sense during the transistion phase.

5. A circuit arrangement as claimed in Claim 4, characterized in that the current source arrangement comprises an emitter-coupled transistor pair (10a, 10b) whose common emitter lead includes a constant current source (12) and whose base difference voltage is determined by at least one RC-element (14a, 16).

6. A circuit arrangement as claimed in Claim 4 or 5, characterized in that a transistor (17) having a high current amplification factor is used as the amplifier, its base being connected to the output of the associated reference $I^2L$ gate whilst its emitter is connected to the injector connection of this $I^2L$ gate (Fig. 2).

## Revendications

1. Montage de circuit comportant plusieurs chemins de signaux formés par des circuits actifs, par l'intermédiaire desquels des signaux de niveaux différents sont amenés à une sortie commune et qui peuvent être activés chacun par une source de courant commutable, caractérisé par les particularités suivantes:

a)   chaque source de courant est formée par au moins une porte porte $I^2L$ (3a . . . 5b),

b)   les portes porte $I^2L$ sont réparties entre un premier (3a, 4a, 5a) et un second (3b, 4b, 5b) groupe, les connexions d'injecteur du premier groupe étant reliées à un premier point de jonction (A) et les connexions d'injecteur du deuxième groupe étant reliées à un second point de jonction B),

c)   les entrées de commande des portes $I^2L$ (3a . . . 5b) sont pilotées d'une manière telle que lors de la transition d'un chemin de signaux à un autre chemin de signaux, deux portes $I^2L$ (par exemple 3b, 4a) appartenant chacune à un des chemins de signaux et à un des groupes peuvent conduire du courant au moins pendant une phase de transition,

d)   les points de jonction (A, B) sont choisis d'une manière telle que, pendant la phase de transition, les courants de sortie des deux portes $I^2L$ varient de manière continue et en sens opposés.

2. Montage de circuit suivant la revendication 1, caractérisé en ce qu'une seule porte $I^2L$ est associée à chaque chemin de signaux et les portes $I^2L$ associées appartiennent alternativement au premier et au second groupe dans l'ordre de grandeur des amplitudes d'entrée des chemins de signaux.

3. Montage de circuit suivant la revendication 1, caractérisé en ce que chaque source de courant est formée par deux portes $I^2L$ (3a, 3b . . . 5a, 5b) qui appartiennent aux deux groupes et dont au moins une est en tout cas conductrice.

4. Montage de circuit suivant les revendications 1 à 3, caractérisé en ce que le premier et le second point de jonction (A, B) sont connectés à la sortie d'un premier et d'un second amplificateur (17a, 17b) ainsi qu'à la connexion d'injecteur d'une première ou d'une seconde porte $I^2L$ de référence (18a, 18b) dont la sortie est connectée à l'entrée du premier et du second amplificateur et un montage de sources de courant (10a . . . 14a, 10b . . . 14b) est prévu et fournit aux entrées des deux amplificateurs (17a, 17b) des courants qui varient en sens opposés pendant la phase de transition.

5. Montage de circuit suivant la revendication 4, caractérisé en ce que le montage de sources de courant comprend une paire de transistors (10a, 10b) couplés par les émetteurs, dans le conducteur d'alimentation d'émetteur commun de laquelle est montée une source de courant constant (12) et dont la tension de différence de base est déterminée par au moins un élément RC (14a, 16) dont la charge peut être modifiée.

6. Montage de circuit suivant la revendication 4 òu 5, caractérisé en ce qu'à titre d'amplification on utilise un transistor (17) à facteur d'amplification de courant élevé dont la base est connectée à la sortie de la porte $I^2L$ de référence associée et dont l'émetteur est connecté à la connexion d'injecteur de cette porte $I^2L$ (Fig. 2).

0 096 944

Fig. 1

9

Fig. 2

Fig. 3a

Fig. 3b

Fig. 3c

Fig. 3d

Fig. 3e

Fig. 3f